# EUROPEAN PATENT SPECIFICATION

(11) **EP 0 913 859 B1**
(45) Date of publication and mention of the grant of the patent: **24.05.2006**
(21) Application number: 98910997.0
(22) Date of filing: 25.03.1998
(51) Int. Cl.: H01L 21/263, H01L 29/739, H01L 29/78

(54) **SEMICONDUCTOR DEVICE AND METHOD FOR MANUFACTURING THE SAME**
HALBLEITERBAUELEMENT UND VERFAHREN ZUR DESSEN HERSTELLUNG
DISPOSITIF A SEMI-CONDUCTEUR ET SON PROCEDE DE FABRICATION

(30) Priority: 25.03.1997 JP 7105697
(43) Date of publication of application: 06.05.1999
(73) Proprietor: ROHM CO., LTD., Kyoto-shi, Kyoto 615-0045 (JP)
(72) Inventor: SAKAMOTO, Kazuhisa, Rohm Co., Ltd., Kyoto-shi Kyoto 615-0045 (JP)
(74) Representative: Beresford, Keith Denis Lewis
(86) International application number: PCT/JP1998/001325
(87) International publication number: WO 1998/043287

(56) References cited:
- EP-A- 0 213 972
- JP-A- 1 235 272
- JP-A- 8 227 895
- JP-A- 51 046 882
- JP-A- 54 002 076
- US-A- 4 134 778
- US-A- 4 682 195
- US-A- 5 025 293
- US-A- 5 169 793
- PATENT ABSTRACTS OF JAPAN vol. 014, no. 070 (E-0886), 8 February 1990 (1990-02-08) -& JP 01 287965 A (MITSUBISHI ELECTRIC CORP), 20 November 1989 (1989-11-20)
- PATENT ABSTRACTS OF JAPAN vol. 013, no. 198 (E-756), 11 May 1989 (1989-05-11) -& JP 01 019771 A (FUJI ELECTRIC CO LTD), 23 January 1989 (1989-01-23)
- ESAKI H ET AL: "A 900 MHz 100 W VD-MOSFET with silicide gate self-aligned channel" INTERNATIONAL ELECTRON DEVICES MEETING. TECHNICAL DIGEST (CAT. NO. 84CH2099-0), SAN FRANCISCO, CA, USA, 9-12 DEC. 1984, pages 447-450, XP002270059 1984, New York, NY, USA, IEEE, USA
- PATENT ABSTRACTS OF JAPAN vol. 016, no. 064 (E-1167), 18 February 1992 (1992-02-18) -& JP 03 259537 A (HITACHI LTD;OTHERS: 01), 19 November 1991 (1991-11-19)
- AKIYAMA H ET AL: "Partial lifetime control in IGBT by helium irradiation through mask patterns" POWER SEMICONDUCTOR DEVICES AND ICS, 1991. ISPSD '91., PROCEEDINGS OF THE 3RD INTERNATIONAL SYMPOSIUM ON BALTIMORE, MD, USA 22-24 APRIL 1991, NEW YORK, NY, USA,IEEE, US, 22 April 1991 (1991-04-22), pages 187-191, XP010044337 ISBN: 0-7803-0009-2
- PATENT ABSTRACTS OF JAPAN vol. 012, no. 196 (E-618), 7 June 1988 (1988-06-07) -& JP 62 298120 A (HITACHI LTD), 25 December 1987 (1987-12-25)

## Description

The present invention relates to a semiconductor device, and a method of manufacturing thereof.

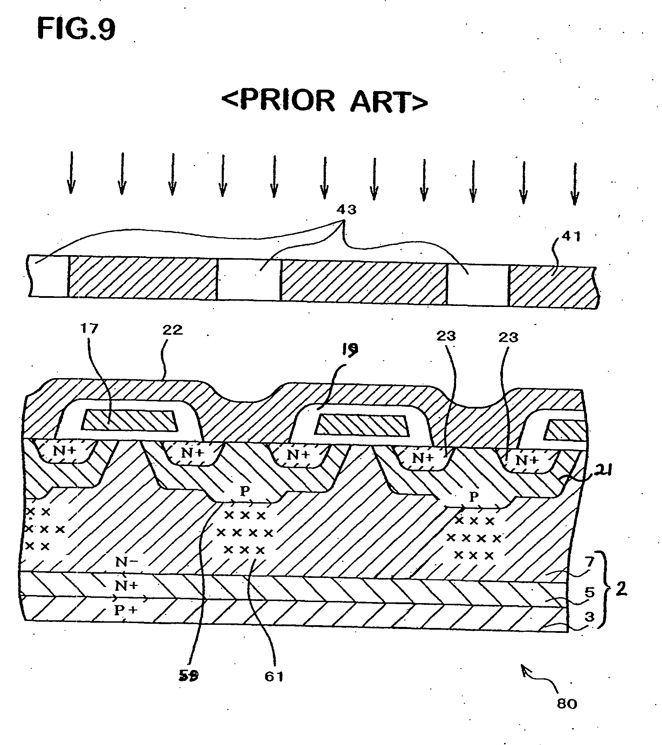

An insulated gate bipolar transistor (hereinafter referred to as IGBT) 80 shown in Fig. 9 is known as a semiconductor device having a planar type high voltage-proof vertical element. The IGBT 80 is a semiconductor device which has both a high input impedance characteristic observed in a metal oxide field effect transistor (hereinafter referred to as MOSFET) and a low saturation voltage characteristic known as a characteristic of a bipolar transistor.

A substrate 2 used for the IGBT 80 includes a drain layer 3 with P⁺ type, an n⁺ type layer 5 and an n⁻ type layer 7. Base regions 21 are formed in the n⁻ type layer 7, and source regions 23 with n⁺ type are formed within the base regions 21. The surface of the n type semiconductor layer 7 is covered with a gate oxidation layer 19.

Incidentally, a loss caused by switching arises as a result of a parasitic diode generated on a plane of a PN (positive-negative) junction 59. Japanese Patent laid-open publication No. Hei 7-135214 discloses a technology for selectively radiating electron-beams using a mask 41 shown in Fig. 9 during the manufacturing processes in order to avoid the generation of the parasitic diode. The beams pass through through-holes 43 formed in the mask 41 and irradiated on the IGBT 80. In this way, the life-time of carriers, located on the plane of the PN junction 59 where the parasitic diode is generated, can be shortened as a result of forming crystal defects 61.

In the manufacturing processes described above,an unexpected variation of the threshold voltage in the IGBT 80 results because of the generation of bremsstrahlung radiation caused by the material of the mask 41 made generally of a heavy metal such as lead and the like.

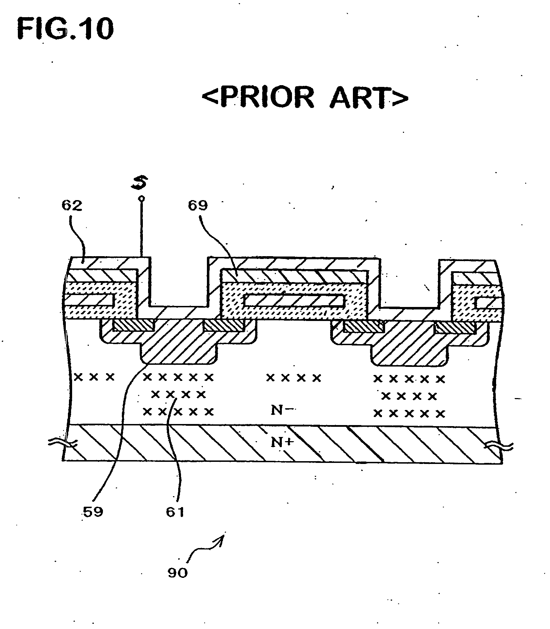

Japanese Patent laid-open publication No. Hei 8-227895 discloses another IGBT 90 having layers for restricting electron-beams. As shown in Fig. 10, a layer 69 made of silicon nitride, for restricting the beams, is formed under the source electrode 62. Generation of the bremsstrahlung radiation is restricted even when the beams are radiated to the IGBT 90 under the condition due to masking by the restriction layer 69.

However, the number of process steps is increased because of the addition of process steps for forming the restriction layers 69 made of silicon nitride required in the conventional method.

It is a concern of the present invention to overcome the above mentioned drawbacks associated with the prior art, and to provide a method of manufacturing a semiconductor device, capable of radiating electron-beams to the desired region with a simple process, while not providing those adverse effects that are caused by bremsstrahlung radiation when the electron-beams are radiated.

The method of manufacturing a semiconductor device considered herein is a method of the kind described in United States Patent US-A-4134778 which is performed by steps of:
providing a substrate having impurity doped regions defined therein, and a metal layer extending over the entire substrate, which metal layer is in electrical contact with said impurity doped regions and has openings defined therein; and
irradiating said substrate while using said metal layer as a mask.

This method is, in accordance with the present invention, characterised in that:
said providing step provides a substrate having, as said metal layer, a metal layer which is of light metal;
said irradiating step is performed at such an energy, and said masking layer is of such a thickness, that not only is a region of crystal defects produced in the substrate beneath each said opening in said metal layer, but amounts of crystal defects are also generated beneath the metal portion of said metal layer; and
an anneal treatment step is performed thereafter to remove said amounts of crystal defects while other crystal defects are left remaining in said region of crystal defects beneath each said opening in said metal layer.

The present invention also provides a semiconductor device as defined by the appended claims.

While the novel features of the invention are set forth in a general fashion, both as to organisation and content, the invention will be better understood and appreciated, along with other objects and features thereof, from the following detailed description taken in conjunction with the drawings. In the accompanying drawings:
Fig. 1 is a sectional view showing part of an IGBT 1 as an embodiment of a semiconductor device in accordance with the present invention;
Fig. 2 is a perspective view of the IGBT 1;
Fig. 3 is a graph showing a relationship between a range of electrons in the source electrode 22 and energy amount of the electron-beams;
Fig. 4A through Fig. 4C are sectional views showing the manufacturing process of the IGBT 1;
Fig. 5A and Fig. 5B are further sectional views showing the manufacturing process of the IGBT 1;
Fig. 6A and Fig. 6B are yet further sectional views showing the manufacturing process of the IGBT 1;
Fig. 7A and Fig. 7B are still further sectional views showing the manufacturing process of the IGBT 1;
Fig. 8 is yet another sectional view showing the manufacturing process of the IGBT 1;
Fig. 9 is a sectional view of the IGBT 80 in the conventional technology; and
Fig. 10 is a sectional view of another IGBT 90 in the conventional technology.

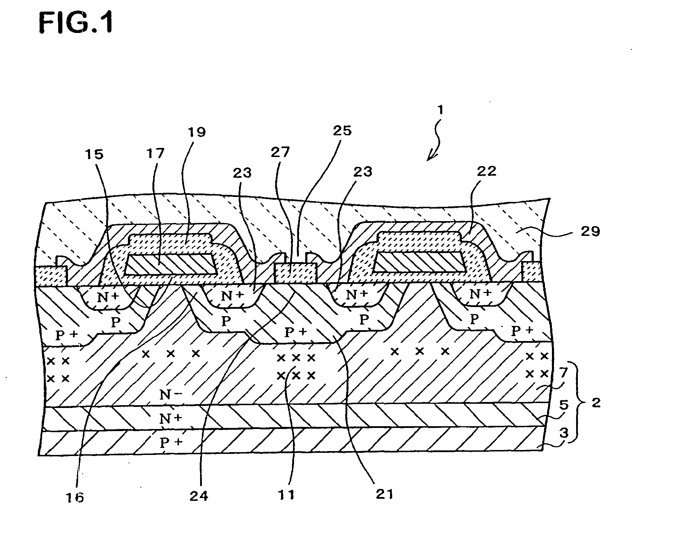

An embodiment of the present invention will be described herein with reference to the drawings. Fig. 1 is a sectional view showing part of an IGBT 1 as one embodiment of a semiconductor device in accordance with the present invention.

The IGBT 1 is formed in a substrate 2 for a semiconductor device. In the substrate 2, an n⁺ type layer 5 and an n type layer 7 are consecutively formed on a drain layer 3 with P⁺ type. A base region 21 with P⁺ type is formed in the n⁻ type layer 7. Source regions 23 are formed in the base region 21. The surface of the n⁻ type layer 7 is covered with a gate oxide layer 15. A gate electrode 17 is formed on the gate oxide layer 15. The gate electrode 17 is covered with an inter-insulating layer 19, and a source electrode 22 made of aluminum is formed on the inter-insulating layer 19. The source electrode 22 formed as a wiring layer made of a metal is also used for electrically connecting with the source regions 23 in the IGBT element. A passivation layer 29 covers the entire surface of the source electrode 22. The first conductive type and the second conductive type are respectively defined as n type and p type in this embodiment.

A silicon oxide layer 27 is formed on a region 24 located between the source regions 23 formed within the base regions 21. An opening 25 is located on the silicon oxide layer 27. On the other hand, a crystal defect region 11 is formed at a position in the n⁻ type layer 7 and below the silicon oxide layers 27.

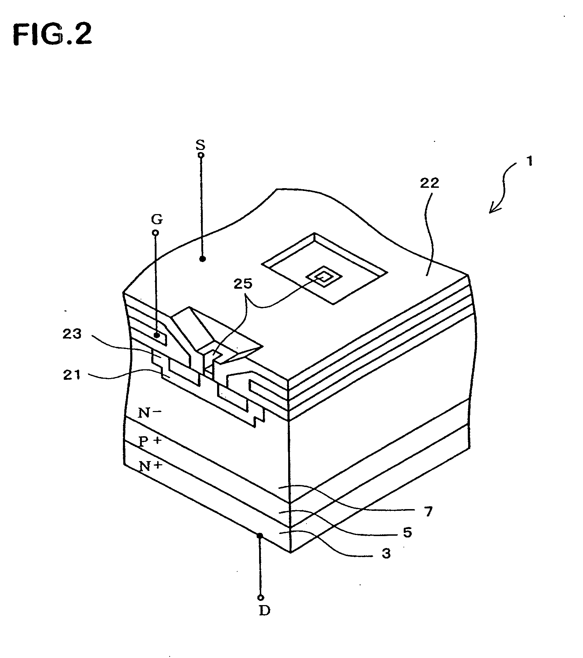

Fig. 2 is a perspective view of the IGBT 1 before forming the passivation layer 29. As described, the silicon oxide layer portion 27 is located above the crystal defect region 11, and the opening 25 is located on the silicon oxide layer portion 27. In this way, the source electrode 22 made of aluminium can be used both for a wiring, and a mask for the beams.

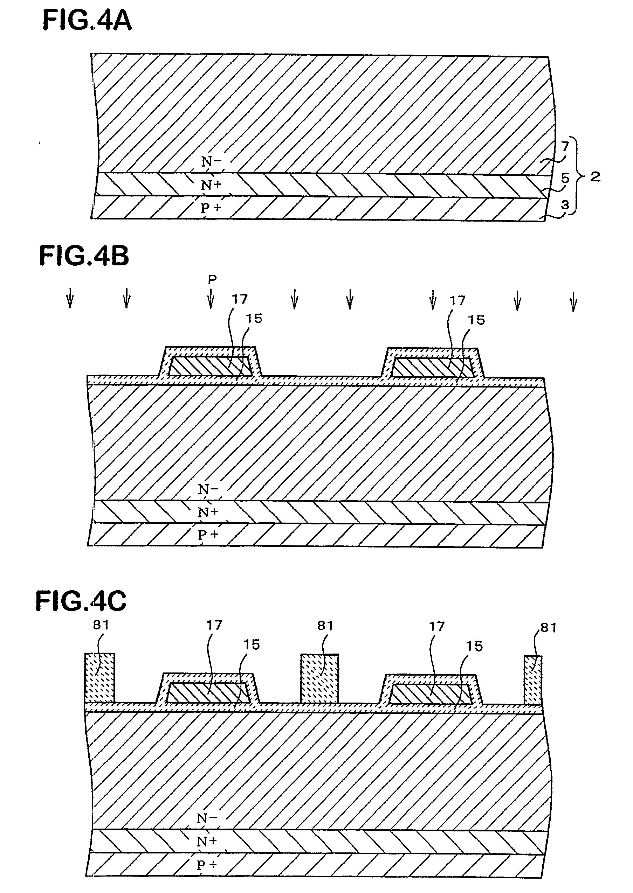

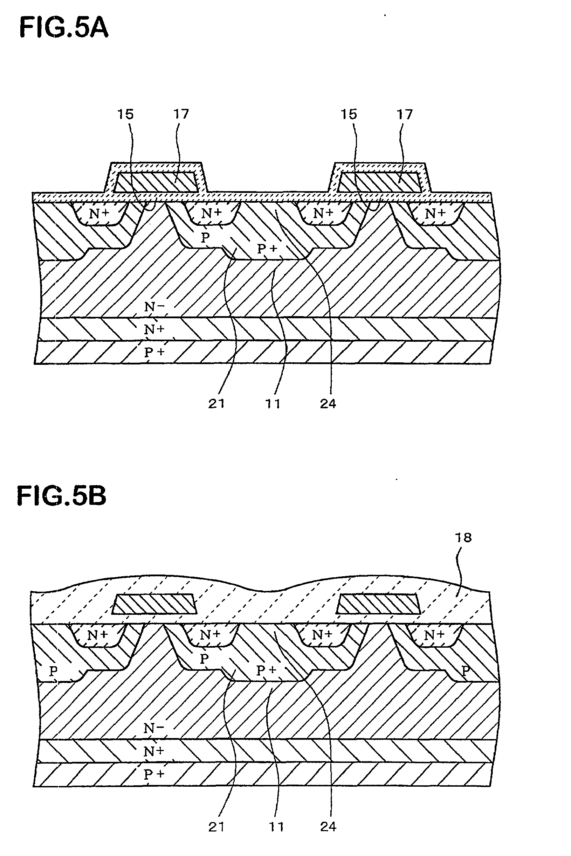

Next, a method of manufacturing the IGBT 1 will be described. The manufacturing processes similar to an ordinary IGBT are carried out until forming the source regions 23. In other words, the substrate 2 is formed by consecutively forming the n⁺ type layer 5 on the drain layer 3 and the n⁻ type layer 7 thereon as shown in Fig. 4A. Thereafter, the gate oxide layer 15 and the gate electrode 17 are formed successively as shown in Fig. 4B. Ion implantation of P-type impurities is carried out by using the gate electrode 17 as a mask. Further, N-type impurities are implanted ionically by using both resist layers 81 formed on the gate oxidation layer 15 and the gate oxide layers 17 as a mask as shown in Fig. 4C. The base region 21 with P⁺ type and a pair of the source regions 23 located in the base region 21 are formed simultaneously by carrying out thermal treatment as shown in Fig. 5A.

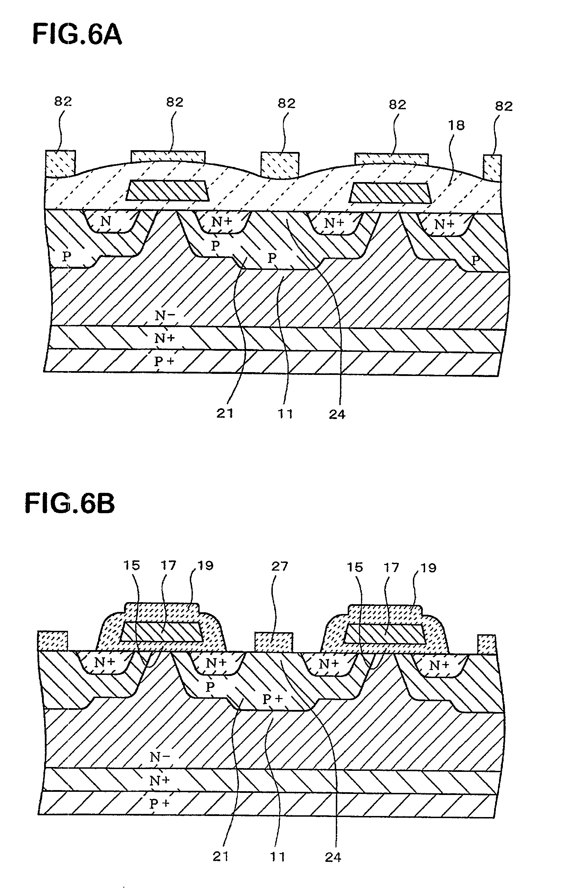

Next, a silicon oxide (SiO₂) layer 18 is accumulated entirely on the substrate with the chemical vapour deposition (CVD) method as shown in Fig. 5B. A resist layer 82 is formed above of both the crystal defect region 11 and the gate electrode 17 as shown in Fig. 6A. Both the inter-insulation layer 19 and the silicon oxide layer 27 are formed with an etch-back technique by using the resist layers 82. In this way, the silicon oxide layer 27 is formed above of the crystal defect region 11 as shown in Fig. 6B.

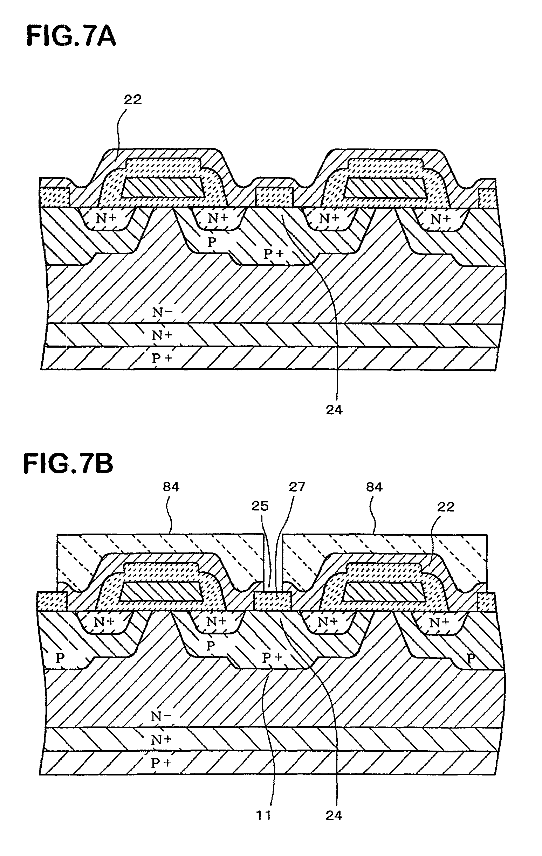

Next, aluminium is deposited over the entire substrate to a thickness of 5 um by the CVD method of deposition as shown in Fig. 7A.

As shown in Fig. 7B, the source electrode formed by carrying out etching using a resist layer 84 being formed. As a result of the etching, the opening 25 is formed on the silicon oxide layer 27.

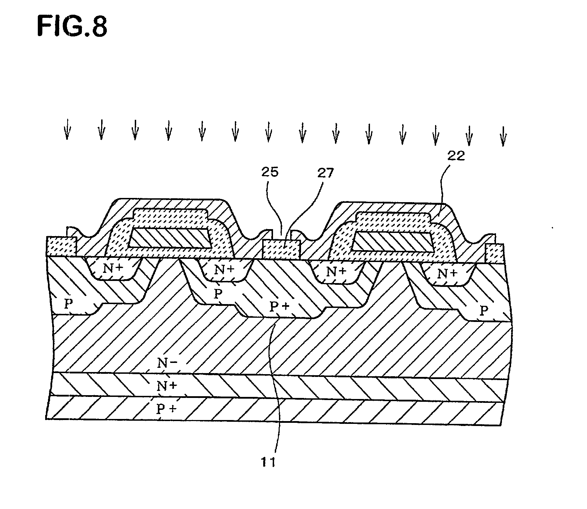

The crystal defect region 11 is irradiated by the electron-beams radiated from the above after removing the resist layer 84 as shown in Fig. 8. The radiation of the beams is carried out at 1 mega electro-volts in energy strength in this embodiment.

By carrying out the radiation, the crystal defect region 11 uncovered with the source electrode 22 is irradiated by the beams, so that desired crystal defects are generated within the region 11. On the other hand, less amount of the beams are irradiated to regions existing outside of the region 11. Although, a certain amount of crystal defects is generated in the regions existing outside of the region 11, these defects can be removed by annealing carried out later. In this way, the IGBT 1 shown in Fig. 1 is manufactured.

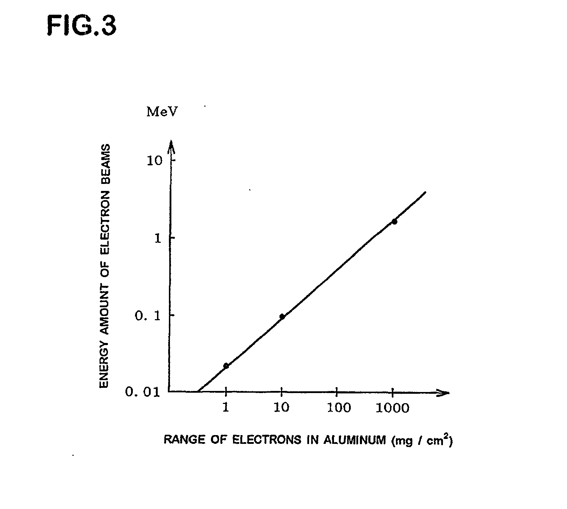

Next, the thickness of the source electrode 22 is described hereunder with reference to a relationship between a range of electrons in the source electrode 22 and energy amount of the beams. As shown in Fig. 3, the range of electrons in aluminium is increased when a higher energy is radiated. Usually, energy strength of the beams forming the crystal defect region is in a range from 600 electro-volts to 1 mega electro-volts. A source electrode 22 of thickness of 0.6 cm to 1 cm is required in order to restrict the generation of the crystal defect region by the source electrode 22 alone. However, a source electrode 22 relatively thicker than an ordinary aluminium wiring having a range from 1 µm to 10 µm is able to restrict the beams because the beams are restricted by the gate electrode 17, the passivation layer 19 and other layers formed thereunder.

Further, the generation of the bremsstrahlung radiation caused by irradiating the source electrode 22 made of a heavy metal can be avoided even when the beams are directly radiated to the source electrode 22 exposed to the air, because the source electrode 22 is made of a light metal e.g. aluminium in this embodiment.

Although, in the embodiment just described, the beams are radiated after removing the resist layer 84, the radiation can be carried out without removing the resist layer 84.

Although the present invention is applied to the manufacture of an IGBT in the embodiments described above, the present invention is also applicable to the manufacture of other types of semiconductors such as a vertical type MOSFET transistor and the like used as a power MOSFET. Further, the present invention can also be used in the manufacture of any semiconductor devices, such as ordinary bipolar transistor, as long as the semiconductor requires the radiation of the beams to a part of the substrate thereof.

Although, in the above example, the source electrode 22 is made of aluminium, other light metals, which do not cause bremsstrahlung radiation such as an aluminium silicon, can be used for the source electrode 22.

Further, the silicon oxide layer 27 is provided in order to form the opening 25 located above the crystal defect region 11.

As described above, the metal layer 22 used for masking and wiring is made of a light metal. Therefore, no generation of bremsstrahlung radiation is observed when electron beam radiation is employed.

The method of the present invention is applicable to the manufacture of an insulated gate bipolar transistor (IGBT), wherein the region that is irradiated is a PN junction region where a parasitic diode is defined. Therefore, it is possible to provide an IGBT in which losses arising during switching, caused by the presence of a parasitic diode, are overcome.

Also, the method of the present invention is applicable to the manufacture of a MOSFET, wherein the region that is irradiated is a PN junction region where a parasitic diode is defined. Therefore, it is possible to provide a MOSFET in which losses arising during switching, caused by the presence of a parasitic diode are overcome.

## Claims

1. A method of manufacturing a semiconductor device performed by steps of:
providing a substrate (2) having impurity doped regions (21,23) defined therein, and a metal layer (22) extending over the entire substrate, which metal layer is in electrical contact with said impurity doped regions and has openings (25) defined therein; and
irradiating said substrate (2) while using said metal layer (22) as a mask;
**characterised in that**:
said providing step provides a substrate having, as said metal layer (22), a metal layer which is of light metal;
said irradiating step is performed at such an energy, and said masking layer is of such a thickness, that not only is a region (11) of crystal defects produced in the substrate (2) beneath each said opening (25) in said metal layer (22), but amounts (13) of crystal defects are also generated beneath the metal portion of said metal layer (22); and
an anneal treatment step is performed thereafter to remove said amounts (13) of crystal defects while other crystal defects are left remaining in said region (11) of crystal defects beneath each said opening (25) in said metal layer.

2. The method of claim 1 wherein said irradiating step is performed while using as said masking metal layer (22) a layer of light metal selected from aluminium or aluminium silicon.

3. The method of either preceding claim wherein the substrate (2) provided in said providing step has an insulator layer (15,19,27) thereon, with openings over said impurity doped regions (23,24), and with insulated gate electrodes (17) disposed in said insulator layer, said metal layer (22) extending over said insulator layer and insulated gate electrodes and contacting said impurity doped regions via said openings thereover.

4. The method of claim 3 wherein said openings (25) defined in said metal layer (22) are each located over a portion (27) of said insulator layer (15,19,27) lying in between adjacent ones of said gate electrodes (17).

5. The method of any preceding claim, being a method of manufacturing insulated gate bipolar transistors, wherein said impurity doped regions (23) are source regions thereof, and said regions (11) of crystal defects are located at parasitic pn diode junctions (21/13) thereof defined in said substrate (2).

6. The method of any preceding claim 1-4, being a method of manufacturing metal oxide semiconductor field effect transistors wherein said impurity doped regions (23) are source regions thereof, and said regions (11) of crystal defects are located at parasitic pn diode junctions thereof defined in said substrate.

7. A semiconductor device comprising:
a substrate (2) having an impurity doped region (23) defined therein;
a metal layer (22) extending over the entire substrate, which metal layer is of light metal, is in electrical contact with said impurity doped region, and has an opening (25) defined therein; and
a region (11) of crystal defects localised in the substrate (2) directly beneath said opening (25) defined in said metal layer (22); wherein
said substrate (2) has an insulator layer (15,19,27) thereon with an opening over said impurity doped region (23) and said metal layer (22) extends over said insulator layer and contacts said impurity doped region via the opening in said insulator layer, and the opening (25) in said metal layer (22) is over said insulator layer.

8. The device of claim 7, being an insulated gate bipolar transistor, wherein said impurity doped region (23) is a source region thereof, and said region (11) of crystal defects is located at a parasitic pn diode junction (21/13) thereof defined in said substrate (2).

9. The device of claim 7, being a metal oxide semiconductor field effect transistor, wherein said impurity doped region (23) is a source region thereof, and said region (11) of crystal defects is located at a parasitic pn diode junction thereof defined in said substrate (2).

## Patentansprüche

1. Ein Verfahren zum Herstellen eines Halbleiterbauelements, ausgeführt durch die Schritte:
Vorsehen eines Substrats (2), das darin definierte mit Störstellen dotierte Gebiete (21, 23) besitzt, und einer Metallschicht (22), die sich über das gesamte Substrat erstreckt, wobei die Metallschicht in elektrischem Kontakt mit den Störstellen-dotierten Gebieten steht und darin definierte Öffnungen (25) besitzt;
und
das Substrat (2) einer Bestrahlung aussetzen, während die Metallschicht (22) als Maske benutzt wird;
**dadurch gekennzeichnet, dass**:
der Schritt des Vorsehens ein Substrat vorsieht, das als die Metallschicht (22) eine Metallschicht besitzt, die aus einem leichten Metall ist;
der Schritt des Aussetzens einer Bestrahlung bei einer solchen Energie verrichtet wird und die maskierende Schicht von einer solchen Dicke ist, dass nicht nur ein Gebiet (11) von Gitterdefekten im Substrat (2) unter jeder der Öffnungen (25) in der Metallschicht (22) erzeugt wird, sondern Mengen (13) von Gitterdefekten auch unter dem Metallgebiet der Metallschicht (22) erzeugt werden; und
ein Ausheilungsschritt danach ausgeführt wird, um die Mengen (13) von Gitterdefekten zu entfernen, während andere Gitterdefekte im Gebiet (11) von Gitterdefekten unter jeder der Öffnungen (25) in der Metallschicht übrig gelassen werden.

2. Das Verfahren nach Anspruch 1, wobei der Schritt des Aussetzen einer Bestrahlung ausgeführt wird, während als die maskierende Metallschicht (22) eine Schicht aus Leichtmetall ausgewählt aus Aluminium oder Aluminium-Silizium benutzt wird.

3. Das Verfahren nach einem der vorhergehenden Ansprüche, wobei das Substrat (2), das im Schritt des Vorsehens vorgesehen ist, eine Isolierschicht (15, 19, 27) darauf hat, mit Öffnungen über den Störstellen-dotierten Gebieten (23, 24), und mit isolierten Gateelektroden (17), die in der Isolierschicht verteilt sind, wobei die Metallschicht (22) sich über die Isolierschicht und die isolierten Gateelektroden erstreckt und die Störstellen-dotierten Gebiete über die Öffnungen darüber kontaktiert.

4. Das Verfahren nach Anspruch 3, wobei die in der Metallschicht (22) definierten Öffnungen (25) jede über einem Gebiet (27) der Isolierschicht (15, 19, 27), das zwischen benachbarten der Gateelektroden (17) liegt, platziert sind.

5. Das Verfahren nach einem der vorhergehenden Ansprüche, das ein Verfahren des Herstellens von Bipolartransistoren mit isolierter Gatelektrode ist, wobei die Störstellen-dotierten Gebiete (23) Source-Gebiete davon sind, und die Gebiete (11) von Gitterdefekten bei parasitären PN-Diodenübergängen (21/13) davon, definiert im Substrat (2), platziert sind.

6. Das Verfahren nach einem der vorhergehenden Ansprüche 1 bis 4, das ein Verfahren des Herstellens von Metall-Oxid-Halbleiter-Feldeffekttransistoren ist, wobei die Störstellen-dotierten Gebiete (23) Source-Gebiete davon sind, und die Gebiete (11) von Gitterdefekten bei parasitären PN-Diodenübergängen davon, definiert im Substrat, platziert sind.

7. Ein Halbleiterbauelement aufweisend:
ein Substrat (2), das ein darin definiertes mit Störstellen dotiertes Gebiet (23) besitzt;
eine Metallschicht (22), die sich über das gesamte Substrat erstreckt, wobei die Metallschicht aus leichtem Metall ist,
in elektrischem Kontakt mit dem Störstellen-dotierten Gebiet steht und eine darin definierte Öffnung (25) besitzt; und
ein Gebiet (11) von Gitterdefekten, das im Substrat (2) direkt unter der in der Metallschicht (22) definierten Öffnung (25) lokalisiert ist; wobei
das Substrat (2) eine Isolierschicht (15, 19, 27) darauf hat, mit einer Öffnung über dem Störstellen-dotierten Gebiet (23), und wobei die Metallschicht (22) sich über die Isolierschicht erstreckt und das Störstellen-dotierte Gebiet über die Öffnung in der Isolierschicht kontaktiert, und
wobei die Öffnung (25) in der Metallschicht (22) über der Isolierschicht ist.

8. Das Bauelement nach Anspruch 7, das ein Bipolartransistor mit isolierter Gatelektrode ist, wobei das Störstellen-dotierte Gebiet (23) ein Source-Gebiet davon ist, und das Gebiet (11) von Gitterdefekten bei einem parasitären PN-Diodenübergang (21/13) davon, definiert im Substrat (2), platziert ist.

9. Das Bauelement nach Anspruch 7, das ein Metall-Oxid-Halbleiter-Feldeffekttransistoren ist, wobei das Störstellen-dotierte Gebiet (23) ein Source-Gebiet davon ist, und das Gebiet (11) von Gitterdefekten bei einem parasitären PN-Diodenübergang davon, definiert im Substrat (2), platziert ist.

## Revendications

1. Procédé de fabrication d'un dispositif à semi-conducteurs réalisé par les étapes consistant à :
fournir un substrat (2) dans lequel des régions dopées aux impuretés (21, 23) sont définies, et une couche de métal (22) s'étendant sur le substrat entier, laquelle couche de métal est en contact électrique avec lesdites régions dopées aux impuretés et a des ouvertures (25) définies dans celles-ci, et
irradier ledit substrat (2) tout en utilisant ladite couche de métal (22) en tant que masque,
**caractérisé en ce que** :
ladite étape de fourniture fournit un substrat ayant, comme ladite couche de métal (22), une couche de métal qui est constituée d'un métal léger,
ladite étape d'irradiation est effectuée à une énergie telle, et ladite couche de masquage est d'une épaisseur telle, que non seulement il existe une région (11) de défauts de cristal produite dans le substrat (2) en dessous de chaque ouverture (25) dans ladite couche de métal (22), mais des quantités (13) de défauts de cristal sont également générées sous la partie métallique de ladite couche de métal (22), et
une étape de traitement de recuit est effectuée par la suite pour retirer lesdites quantités (13) de défauts de cristal tandis que d'autres défauts de cristal sont laissés dans ladite région (11) de défauts de cristal sous chaque ouverture (25) dans ladite couche de métal.

2. Procédé selon la revendication 1, dans lequel ladite étape d'irradiation est effectuée tout en utilisant en tant que couche de métal de masquage (22) une couche de métal léger sélectionné parmi l'aluminium ou le silicium d'aluminium.

3. Procédé selon l'une quelconque des revendications précédentes, dans lequel sur le substrat (2) fourni dans ladite étape de fourniture se trouve une couche isolante (15, 19, 27), ayant des ouvertures sur lesdites régions dopées aux impuretés (23, 24), ayant des électrodes à grille isolée (17) disposées dans ladite couche isolante, ladite couche de métal (22) s'étendant sur ladite couche isolante et lesdites électrodes à grille isolée et étant en contact avec lesdites régions dopées aux impuretés via lesdites ouvertures sur celles-ci.

4. Procédé selon la revendication 3, dans lequel lesdites ouvertures (25) définies dans ladite couche de métal (22) sont chacune placée sur une partie (27) de ladite couche isolante (15, 19, 27) comprise entre des électrodes adjacentes parmi lesdites électrodes à grille (17).

5. Procédé selon l'une quelconque des revendications précédentes, étant un procédé de fabrication de transistors bipolaires à grille isolée, dans lequel lesdites régions dopées aux impuretés (23) sont des régions de sources de ceux-ci, et lesdites régions (11) de défauts de cristal sont situées à des jonctions de diode pn parasites (21/13) de ceux-ci définies dans ledit substrat (2).

6. Procédé selon l'une quelconque des revendications 1 à 4, étant un procédé de fabrication de transistors métal-oxyde à effet de champ dans lequel lesdites régions dopées aux impuretés (23) sont des régions de sources de ceux-ci, et lesdites régions (11) de défauts de cristal sont situées à des jonctions de diode pn parasites de ceux-ci définies dans ledit substrat.

7. Dispositif à semi-conducteurs, comportant :
un substrat (2) dans lequel est définie une région dopée aux impuretés (23);
une couche de métal (22) s'étendant sur le substrat entier, laquelle couche de métal est constituée d'un métal léger, est en contact électrique avec ladite région dopée aux impuretés, et dans laquelle est définie une ouverture (25), et
une région (11) de défauts de cristal localisée dans le substrat (2) directement sous ladite ouverture (25) définie dans ladite couche de métal (22), dans lequel
sur ledit substrat (2) se trouve une couche isolante (15, 19, 27) ayant une ouverture sur ladite région dopée aux impuretés (23) et ladite couche de métal (22) s'étend sur ladite couche isolante et est contact avec ladite région dopée aux impuretés via l'ouverture dans ladite couche isolante, et l'ouverture (25) dans ladite couche de métal (22) se trouve sur ladite couche isolante.

8. Dispositif selon la revendication 7, étant un transistor bipolaire à grille isolée, dans lequel ladite région dopée aux impuretés (23) est une région de source de celui-ci, et ladite région (11) de défauts de cristal est située à une jonction de diode pn parasite (21/13) de celui-ci définie dans ledit substrat (2).

9. Dispositif selon la revendication 7, étant un transistor métal-oxyde à effet de champ, dans lequel ladite région dopée aux impuretés (23) est une région de source de celui-ci, et ladite région (11) de défauts de cristal est située à une jonction de diode pn parasite de celui-ci définie dans ledit substrat (2).
